# EUROPÄISCHE PATENTSCHRIFT

(11) **EP 4 098 979 B1**
(45) Veröffentlichungstag und Bekanntmachung des Hinweises auf die Patenterteilung: **24.01.2024**
(21) Anmeldenummer: 22174595.3
(22) Anmeldetag: 20.05.2022
(51) Int. Cl.: G01D 3/08, G01D 21/00

(54) **MESSSYSTEM ZUR ERFASSUNG EINES PHYSIKALISCHEN PARAMETERS UND VERFAHREN ZUM BETREIBEN EINES MESSSYSTEMS**
MEASURING SYSTEM FOR DETERMINING A PHYSICAL PARAMETER AND METHOD FOR OPERATING A MEASURING SYSTEM
SYSTÈME DE MESURE DESTINÉ À LA DÉTECTION D'UN PARAMÈTRE PHYSIQUE ET PROCÉDÉ PERMETTANT DE FAIRE FONCTIONNER UN SYSTÈME DE MESURE

(30) Priorität: 01.06.2021 DE 102021114097
(43) Veröffentlichungstag der Anmeldung: 07.12.2022
(73) Patentinhaber: KNORR-BREMSE Systeme für Nutzfahrzeuge GmbH, 80809 München (DE)
(72) Erfinder: BELLING-HOFFMANN, Michael, 71272 Renningen (DE); KAUFMANN, Christian, 71063 Sindelfingen (DE); DRAYß, Dominikus, 74731 Walldürn (DE); RAMMERT, Alexander, 70806 Kornwestheim (DE)

(56) Entgegenhaltungen:
- DE-A1-102017 108 207
- DE-A1-102018 121 960
- DE-A1-102018 204 615
- DE-A1-102019 100 354

## Beschreibung

Die Erfindung geht von einem Messsystem oder einem Verfahren nach Gattung der unabhängigen Ansprüche aus. Gegenstand der vorliegenden Erfindung ist auch ein Computerprogramm.

In modernen Sensorsystemen, speziell die in Fahrzeugen verbaut sind, sollte sichergestellt sein, dass diese Sensorsysteme möglichst gut gegen einen Ausfall von Systemkomponenten geschützt sind. Hierzu ist es oftmals üblich, redundante Systeme oder Energieversorgungseinheiten vorzusehen, durch welche ein Messsensor mit Energie versorgt wird, sodass bei einem Ausfall eines solchen Energieversorgungssystems ein redundantes Energieversorgungssystem zur Speisung des Messensors mit Energie einspringt. Problematisch ist jedoch, wenn die Energieversorgungssysteme einen unterschiedlichen Massebezug aufweisen, sodass der Messsensor zumindest zeitweise nicht mit einer im tolerierten Bereich liegenden Spannung versorgt wird und hierdurch gegebenenfalls bei einem Wechsel des aktiven Energieversorgungssystems entweder keine oder fehlerhafte Messwerte liefert.

Die DE 10 2019 100 354 A1 offenbart eine Vorrichtung zum Bestimmen einer Drehzahl zumindest eines Rades eines Fahrzeugs. Die Vorrichtung umfasst eine Erfassungseinrichtung, ein erstes Steuergerät mit einer ersten Messeinrichtung und ein zweites Steuergerät mit einer zweiten Messeinrichtung, wobei die Erfassungseinrichtung elektrisch zwischen die erste Messeinrichtung und die zweite Messeinrichtung schaltbar oder geschaltet ist. Es kann insbesondere ein Sensorsignal von einem aktiven Drehzahlsensor zum Bestimmen der Drehzahl redundant eingelesen, genutzt und/oder ausgewertet werden.

### Offenbarung der Erfindung

Vor diesem Hintergrund werden mit dem hier vorgestellten Ansatz ein Messsystem, weiterhin ein Verfahren zum Betreiben dieses Messystems, sowie schließlich ein entsprechendes Computerprogramm gemäß den Hauptansprüchen vorgestellt. Durch die in den abhängigen Ansprüchen aufgeführten Maßnahmen sind vorteilhafte Weiterbildungen und Verbesserungen des im unabhängigen Anspruch angegebenen Messsystems möglich.

Es wird daher ein Messsystem zur Erfassung eines physikalischen Parameters vorgestellt, wobei das Messsystem die folgenden Merkmale aufweist:
- einen Messsensor zur Erfassung des physikalischen Parameters, wobei der Messsensor einen ersten Anschluss, einen zweiten Anschluss, zumindest einen dritten Anschluss aufweist;
- eine erste Energieversorgungseinheit zur Ausgabe von elektrischer Energie an den Messsensor über den ersten Anschluss und den zweiten Anschluss, wobei die erste Energieversorgungseinheit ausgebildet ist, um die elektrische Energie mit einer ersten Spannung in Bezug auf ein erstes Massepotenzial an den Messsensor auszugeben; und
- eine zweite Energieversorgungseinheit zur Ausgabe von elektrischer Energie an den Messsensor über den dritten Anschluss und den zweiten oder einen vierten Anschluss, wobei die zweite Energieversorgungseinheit ausgebildet ist, um die elektrische Energie mit einer zweiten Spannung in Bezug auf ein zweites Massepotenzial an den Messsensor auszugeben, insbesondere wobei das erste Massepotenzial zumindest temporär von dem zweiten Massepotenzial abweicht,
wobei die erste Energieversorgungseinheit eine zusätzliche Spannungsquelle aufweist, wobei der zweite Anschluss des Messsensors über die zusätzliche Spannungsquelle mit dem ersten Massepotenzial elektrisch verbunden ist.

Unter einem physikalischen Parameter kann beispielsweise eine physikalische Größe wie eine Drehzahl, eine Beschleunigung, eine Temperatur oder dergleichen verstanden werden. Unter einer Energieversorgungseinheit kann beispielsweise eine Einheit verstanden werden, die elektrische Energie in Form eines Stroms und/oder einer Spannung an den Messsensor bereitstellt. Hierbei können die erste Energieversorgungseinheit und die zweite Energieversorgungseinheit auf unterschiedlichen Massepotenzialen gestützt sein, beispielsweise aufgrund einer galvanischen Trennung oder aufgrund von zwischen diesen Massepotenzialen liegenden langen elektrischen Verbindungsleitungen, die als elektrischer Widerstand dienen und die beim Führen eines elektrischen Stroms dazu führen, dass sich die Massepotenziale voneinander unterscheiden. Die erste Energieversorgungseinheit kann als eine primäre Energieversorgungseinheit fungieren. Die zweite Energieversorgungseinheit kann als eine redundante Energieversorgungseinheit fungieren. Die erste Energieversorgungseinheit kann ein Steuergerät, beispielsweise einen elektropneumatischen Modulator oder dergleichen, aufweisen oder ein Teil desselben sein. Die zweite Energieversorgungseinheit kann ein Steuergerät aufweisen oder ein Teil desselben sein.

Der hier vorgeschlagene Ansatz basiert auf der Erkenntnis, dass durch eine zusätzliche Spannungsquelle zur Potenzialanhebung eine Verbesserung einer Überwachungsfunktion bei einer Diagonalversorgung von Messsensoren, insbesondere aktiven Drehzahlfühlern erzielt werden kann. Im Gegensatz zu herkömmlichen elektrischen Schaltungen kann gemäß Ausführungsformen ein Einlesen und Überwachen eines Messsensors, beispielsweise eines aktiven Drehzahlfühlers, parallel von zwei Steuergeräten auch bei Masseversätzen zwischen den beiden Steuergeräten realisiert werden. Durch die zusätzliche Spannungsquelle kann verhindert werden, dass durch Masseversätze eine negative Spannung entstehen kann, welche dazu führen würde, dass Sensorspannungen nicht erfasst werden könnten. Somit können unabhängig von Masseversätzen zuverlässige Sensordaten beispielsweise bezüglich einer Raddrehzahl für ein Bremssystem erhalten werden und kann somit eine Betriebssicherheit erhöht werden. Eine diagonale Versorgung und das Einlesen von aktiv erfassten Drehzahlen können aufgrund der sicheren Sensordatenerfassung auf vorteilhafte Weise zum automatisierten und autonomen Fahren verwendet werden. Hinsichtlich des Masseversatzes kann die zusätzliche Spannungsquelle zur Potenzialanhebung verwendet werden. Beispielsweise kann davon ausgegangen werden, dass Masseversätze von bis zu +/- 3 V auftreten können, wobei andere Werte ebenfalls möglich sind. Die zusätzliche Spannungsquelle kann die Bezugsmasse des Messsystems gegenüber dem ersten Massepotential anheben. In der zweiten Energieversorgungseinheit bzw. dem zweiten Steuergerät kann dadurch insbesondere eine Rückmeldung an einer Steuereinrichtung im Massepfad angehoben werden. Durch Anpassung eines Widerstandsnetzwerks auf das neue Bezugspotenzial kann somit beispielsweise ein Messbereich verschoben werden. Ferner kann vorteilhafterweise eine verbesserte thermische Ausbalanciertheit des Messsystems erreicht werden, da insbesondere ein Linearregler in der zweiten Energieversorgungseinheit entlastet werden kann.

Durch das Anheben des Bezugspotentials können neue Fehlerbilder detektiert werden, welche die Koordination zwischen den Steuergeräten erheblich vereinfachen. Ein Kurzschluss zu Masse beispielsweise ist nun vom zweiten Steuergerät selbstständig detektierbar und die Totzeit im Übergang zum Redundanzmodus wird verringert. Weitergehend könnte über die Masseanhebung des jeweils anderen Steuergerät Rückschlüsse über die Aktivitäten ermöglichen. Werden Akuatoren angesteuert, ist ein Bremsvorgang/ABS-Regelung naheliegend. Über diese Zusammenhänge könnten geeignete Maßnahmen, beispielsweise ein Vorspannen einer Backupleitung, eingeleitet werden, welche den Übergang vom Primären zum Sekundären Steuergerät beschleunigen.

Gemäß einer Ausführungsform kann die erste Energieversorgungseinheit eine erste Spannungsquelle für die erste Spannung und eine erste Steuereinrichtung umfassen. Hierbei kann der erste Anschluss des Messsensors mit der ersten Spannungsquelle und mit der ersten Steuereinrichtung elektrisch verbunden sein. Insbesondere kann hierbei die erste Steuereinrichtung über einen ersten Spannungsteiler elektrisch mit dem ersten Anschluss des Messsensors und mit dem ersten Massepotenzial verbunden sein. Eine solche Ausführungsform des hier vorgeschlagenen Ansatzes bietet den Vorteil, dass eine Versorgung des Messsensors mit elektrischer Energie sowie ein Einlesen von Messwerten auf einfache Weise umgesetzt werden können.

Auch kann die erste Energieversorgungseinheit eine erste Verstärkungseinrichtung und eine zweite Steuereinrichtung umfassen. Hierbei kann der zweite Anschluss des Messsensors mit der ersten Verstärkungseinrichtung und der zweiten Steuereinrichtung elektrisch verbunden sein. Insbesondere kann hierbei die zweite Steuereinrichtung über einen zweiten Spannungsteiler elektrisch mit dem zweiten Anschluss des Messsensors und mit dem ersten Massepotenzial verbunden sein. Bei der Verstärkungseinrichtung kann es sich um einen Operationsverstärker, Differenzverstärker oder dergleichen handeln. Eine solche Ausführungsform des hier vorgeschlagenen Ansatzes bietet den Vorteil, dass eine zuverlässige und genaue Erfassung von Messwerten erreicht werden kann.

Ferner kann die zweite Energieversorgungseinheit eine zweite Spannungsquelle für die zweite Spannung, eine zweite Verstärkungseinrichtung und eine dritte Steuereinrichtung umfassen. Hierbei kann der dritte Anschluss des Messsensors mit der zweiten Spannungsquelle, mit der zweiten Verstärkungseinrichtung und mit der dritten Steuereinrichtung elektrisch verbunden sein. Insbesondere kann hierbei die dritte Steuereinrichtung über einen dritten Spannungsteiler elektrisch mit dem dritten Anschluss des Messsensors und mit dem zweiten Massepotenzial verbunden sein. Eine solche Ausführungsform des hier vorgeschlagenen Ansatzes bietet den Vorteil, dass eine sichere Diagonalversorgung des Messsensors und eine exakte Erfassung des physikalischen Parameters ermöglicht werden können.

Zudem kann die zweite Energieversorgungseinheit eine vierte Steuereinrichtung umfassen. Hierbei kann der zweite oder vierte Anschluss des Messsensors mit der vierten Steuereinrichtung elektrisch verbunden sein. Insbesondere kann hierbei die vierte Steuereinrichtung über einen vierten Spannungsteiler elektrisch mit dem zweiten oder vierten Anschluss des Messsensors und mit dem zweiten Massepotenzial verbunden sein. Eine solche Ausführungsform des hier vorgeschlagenen Ansatzes bietet den Vorteil, dass auf einfache Weise ein robuster Aufbau des Messsystems erzielt werden kann.

Auch kann gemäß einer speziellen Ausführungsform der Messsensor als Drehzahlsensor ausgebildet sein, insbesondere um eine Drehzahl einer Komponente eines Fahrzeugs und/oder eines Rads eines Fahrzeugs zu erfassen. Eine solche Ausführungsform des hier vorgeschlagenen Ansatzes bietet den Vorteil, insbesondere in einer Umgebung mit hohen Sicherheitsanforderungen eine zuverlässige und robuste Messung des physikalischen Parameters durch den Messsensor gewährleisten zu können.

Auch wird gemäß einer Ausführungsform des hier vorgeschlagenen Ansatzes ein Verfahren zum Betreiben eines Messsystems gemäß einer Variante des hier vorgestellten Ansatzes vorgeschlagen, wobei das Verfahren die folgenden Schritte umfasst:
- Versorgen des Messsensors mit elektrischer Energie aus der ersten und/oder zweiten Energieversorgungseinheit; und
- Ausgeben eines Messignals durch den Messsensor, wobei das Messignal den physikalischen Parameter repräsentiert.

Auch durch eine solche Ausführungsform in Form eines Verfahrens lassen sich die vorstehend genannten Vorteile technisch einfach realisieren, sodass der physikalische Parameter mit einer hohen Sicherheit und Robustheit erfasst und verwendet werden kann.

Von Vorteil ist auch ein Computerprogrammprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann und zur Durchführung, Umsetzung und/oder Ansteuerung der Schritte des Verfahrens nach einer der vorstehend beschriebenen Ausführungsformen verwendet wird, insbesondere wenn das Programmprodukt oder Programm auf einem Computer oder einer Vorrichtung ausgeführt wird.

Ausführungsbeispiele des hier vorgestellten Ansatzes sind in den Zeichnungen dargestellt und in der nachfolgenden Beschreibung näher erläutert. Es zeigt:
- Fig. 1: ein Blockschaltbild eines Ausführungsbeispiels des hier vorgestellten Messsystems in der Verschaltung für den Normalbetrieb; und
- Fig. 2: ein Ablaufdiagramm eines Ausführungsbeispiels des hier vorgestellten Ansatzes als Verfahren zum Betreiben einer Variante eines hier beschriebenen Messsystems.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

**Fig. 1** zeigt ein Blockschaltbild eines Ausführungsbeispiels des hier vorgestellten Messsystems 100 zur Erfassung eines physikalischen Parameters. Das Messsystem 100 umfasst hierbei einen Messsensor 105, der mit elektrischer Energie aus einer ersten Energieversorgungseinheit 110 und/oder mit elektrischer Energie aus einer zweiten Energieversorgungseinheit 115 gespeist wird. Der Messsensor 105 ist ausgebildet, um den physikalischen Parameter zu erfassen.

Der Messsensor 105 kann beispielsweise als Sensor für eine physikalische Größe bzw. einen physikalischen Parameter wie eine Drehzahl eines Rades eines Fahrzeugs ausgestaltet sein. Denkbar ist jedoch auch, dass der Messsensor 105 als Sensor für eine Temperatur, eine Beschleunigung, einen Druck oder dergleichen ausgestaltet ist. Die erste Energieversorgungseinheit 110 umfasst ein Steuergerät oder primäres Steuergerät, lediglich beispielhaft einen elektropneumatischen Modulator, oder ist als ein Teil desselben ausgeführt. Die zweite Energieversorgungseinheit 115 umfasst ein weiteres Steuergerät oder redundantes Steuergerät.

Der Messsensor 105 ist elektrisch zwischen die erste Energieversorgungseinheit 110 und die zweite Energieversorgungseinheit 115 geschaltet. Der Messsensor 105 umfasst einen ersten Anschluss A, einen zweiten Anschluss B, einen dritten Anschluss C und einen vierten Anschluss D. In dem in der Fig. 1 dargestellten Ausführungsbeispiel ist dabei der zwite Anschluss elektrisch leitfähig mit dem vierten Anschluss verbunden. Über die Anschlüsse A, B, C und D ist der Messsensor 105 elektrisch an die Energieversorgungseinheiten 110 und 115 angeschlossen.

Die erste Energieversorgungseinheit 110 ist ausgebildet, um über einen ersten Schalter S1 zum ersten Anschluss A und einen zweiten Schalter S2 zum zweiten Anschluss B elektrische Energie an den Messsensor 105 auszugeben. Dabei ist die erste Energieversorgungseinheit 110 ausgebildet, um die elektrische Energie mit einer ersten Spannung U1 in Bezug auf ein erstes Massepotenzial GND1 an den Messsensor 105 auszugeben. Die erste Energieversorgungseinheit 110 umfasst eine zusätzliche Spannungsquelle 140, über welche der zweite Anschluss B des Messsensors 105 elektrisch mit dem ersten Massepotenzial GND1 verbunden ist.

Die zweite Energieversorgungseinheit 115 ist ausgebildet, um über einen dritten Schalter S3 zum dritten Anschluss C und einen vierten Schalter S4 zum vierten Anschluss D elektrische Energie an den Messsensor 105 auszugeben. Dabei ist die zweite Energieversorgungseinheit 115 ausgebildet ist, um die elektrische Energie mit einer Sensorspannung U_{Sensor} an den Messsensor 105 auszugeben. Das erste Massepotenzial GND1 kann zumindest temporär von dem zweiten Massepotenzial GND2 abweichen. Diese Abweichung kann sich beispielsweise aufgrund von zwischen den Massepotenzialen GND1 und GND2 liegenden langen elektrischen Verbindungsleitungen ergeben, die als elektrischer Widerstand fungieren und die beim Führen eines elektrischen Stroms dazu führen, dass sich die Massepotenziale voneinander unterscheiden.

Gemäß dem in Fig. 1 dargestellten Ausführungsbeispiel umfasst die erste Energieversorgungseinheit 110 eine erste Spannungsquelle 120 für die erste Spannung U1, eine erste Verstärkungseinrichtung 130, eine erste Steuereinrichtung 150 (die auch als Regeleinrichtung arbeiten kann) und eine zweite Steuereinrichtung 160 sowie eine Mehrzahl von elektrischen Widerständen R1, R2, R3, R4 und R5. Ferner umfasst gemäß dem in Fig. 1 dargestellten Ausführungsbeispiel die zweite Energieversorgungseinheit 115 eine zweite Spannungsquelle 125 für die zweite Spannung U2, eine zweite Verstärkungseinrichtung 135, eine dritte Steuereinrichtung 170 und eine vierte Steuereinrichtung 180 sowie eine Mehrzahl von elektrischen Widerständen R6, R7, R8, R9 und R10. Die Verstärkungseinrichtungen 130 und 135 sind beispielsweise als Differenzverstärker, Operationsverstärker oder dergleichen ausgeführt.

Die erste Spannungsquelle 120 der ersten Energieversorgungseinheit 110 ist ausgebildet, um die erste Spannung U1 in Bezug auf das erste Massepotenzial GND1 bereitzustellen. Der erste Anschluss A des Messsensors 105 ist elektrisch mit der ersten Spannungsquelle 120 und mit der ersten Steuereinrichtung 150 verbunden. Dabei ist die erste Spannungsquelle 120 elektrisch zwischen das erste Massepotenzial GND1 und den ersten Anschluss A geschaltet. Die erste Steuereinrichtung 150 ist über einen ersten Spannungsteiler, der einen ersten elektrischen Widerstand R1 und einen zweiten elektrischen Widerstand R2 umfasst, elektrisch mit dem ersten Anschluss A des Messsensors 105 und mit dem ersten Massepotenzial GND1 verbunden. Der erste Spannungsteiler bzw. die elektrischen Widerstände R1 und R2 sind hierbei elektrisch zwischen das erste Massepotenzial GND1 und den ersten Anschluss A geschaltet. Die erste Steuereinrichtung 150 ist elektrisch mit einem Abgriffspunkt zwischen den elektrischen Widerständen R1 und R2 verbunden.

Die erste Verstärkungseinrichtung 130 und die zweite Steuereinrichtung 160 der ersten Spannungsquelle 120 sind elektrisch mit dem zweiten Anschluss B des Messsensors 105 verbunden. Ferner ist die zusätzliche Spannungsquelle 140 elektrisch mit dem zweiten Anschluss B des Messsensors 105 verbunden. Dabei sind die erste Verstärkungseinrichtung 130 und die zusätzliche Spannungsquelle 140 elektrisch zwischen das erste Massepotenzial GND1 und den zweiten Anschluss B geschaltet. Ferner ist hierbei die erste Verstärkungseinrichtung 130 elektrisch zwischen die zusätzliche Spannungsquelle 140 und den zweiten Anschluss B geschaltet. Ein fünfter elektrischer Widerstand R5 ist elektrisch zwischen zwei Anschlüsse der ersten Verstärkungseinrichtung 130 geschaltet. Die zweite Steuereinrichtung 160 ist über einen zweiten Spannungsteiler, der einen dritten elektrischen Widerstand R3 und einen vierten elektrischen Widerstand R4 umfasst, elektrisch mit dem zweiten Anschluss B des Messsensors 105 und mit dem ersten Massepotenzial GND1 verbunden. Der zweite Spannungsteiler bzw. die elektrischen Widerstände R3 und R4 sind hierbei elektrisch zwischen das erste Massepotenzial GND1 und den zweiten Anschluss B geschaltet. Die zweite Steuereinrichtung 160 ist elektrisch mit einem Abgriffspunkt zwischen den elektrischen Widerständen R3 und R4 verbunden.

Die zweite Spannungsquelle 125 der zweiten Energieversorgungseinheit 115 ist ausgebildet, um die Sensorspannung U_{Sensor} bereitzustellen. Der dritte Anschluss C des Messsensors 105 ist elektrisch mit der zweiten Spannungsquelle 125, mit der zweiten Verstärkungseinrichtung 135 und mit der dritten Steuereinrichtung 170 verbunden. Die zweite Spannungsquelle 125 ist elektrisch zwischen das zweite Massepotenzial GND2 und die zweite Verstärkungseinrichtung 135 geschaltet. Ein sechster elektrischer Widerstand R6 ist elektrisch zwischen zwei Anschlüsse der zweiten Verstärkungseinrichtung 135 geschaltet. Die dritte Steuereinrichtung 170 ist über einen dritten Spannungsteiler, der einen siebten elektrischen Widerstand R7 und einen achten elektrischen Widerstand R8 umfasst, elektrisch mit dem dritten Anschluss C des Messsensors 105 und mit dem zweiten Massepotenzial GND2 verbunden. Der dritte Spannungsteiler bzw. die elektrischen Widerstände R7 und R8 sind hierbei elektrisch zwischen das zweite Massepotenzial GND2 und den dritten Anschluss C geschaltet. Die dritte Steuereinrichtung 170 ist elektrisch mit einem Abgriffspunkt zwischen den elektrischen Widerständen R7 und R8 verbunden.

Die vierte Steuereinrichtung 180 ist elektrisch mit dem zweiten Anschluss B oder dem vierten Anschluss D des Messsensors 105 verbunden. Die vierte Steuereinrichtung 180 ist über einen vierten Spannungsteiler, der einen neunten elektrischen Widerstand R9 und einen zehnten elektrischen Widerstand R10 umfasst, elektrisch mit dem zweiten Anschluss B oder dem vierten Anschluss D des Messsensors 105 und mit dem zweiten Massepotenzial GND2 verbunden. Der vierte Spannungsteiler bzw. die elektrischen Widerstände R9 und R10 sind hierbei elektrisch zwischen das zweite Massepotenzial GND2 und den zweiten Anschluss B oder dem vierten Anschluss D geschaltet. Die vierte Steuereinrichtung 180 ist elektrisch mit einem Abgriffspunkt zwischen den elektrischen Widerständen R9 und R10 verbunden.

Denkbar wäre auch ein in der Fig.1 nicht explizit dargestelltes Ausführungsbeispiel, bei der am vierten Anschluss D eine Verstärkerschaltung eingesetzt werden, wie sie beispielsweise der Verstärkerschaltung mit dem fünften Widerstand R5, der ersten Verstärkungseinrichtung 130 und der zusätzlichen Spannungsquelle 140 am ersten Massepotenzial GND1 entspricht. Alternativ oder zusätzlich kann auch am ersten Anschluss A eine Verstärkerschaltung eingesetzt werden, wie sie beispielsweise der Verstärkerschaltung mit dem sechsten Widerstand R6 und der zweiten Verstärkungseinrichtung 135 am dritten Anschluss C entspricht. Durch einen solchen vollsymmetrischen Aufbau können beispielsweise weitere Fehlerfälle erkannt, behandelt oder kompensiert werden.

Prinzipiell ist anzumerken, dass der hier vorgestellte Anstaz nicht nur für Sensoren mit zwei Drähten (also vier Anschlüssen bei Diagonalbetrieb) eingesetzt werden kann, sondern auch für Sensoren mit einer anderen Anzahl von Drähten geeignet ist, wobei der Sensor zumindest drei Eingänge für die Enerigeversorgung aufweisten sollte, um die unterschiedlichen Energieversorgungsmodule, die auf unterschiedlichen Potenzialen liegen, hinreichend voneinander entkoppelt an den Sensor anzuschließen.

Beispielsweite kann ein Sensor mit unterschiedlichen Anschlüssen verwendet werden, beispielsweise für die Kontakte VDD, GND, Sig, wobei VDD und GND in identischer Weise mit beiden ECUs verbunden ist und ein Signalanschluss Sig einen Messwert liefert. Darüber hinaus wird zudem das Signal "Sig" an beide ECUs geführt.

Angenommen dieses Messignal Sig gibt einen Wert aus, der zwischen den Pegeln von GND (z. B. 0 V) und VDD (z.B. 5 V) liegt. Wenn die ECU A (z. B. die erste Energieversorgungseinheit 110 die Versorgungsleitung VDD speist und eine differenzielle Spannung in Höhe von 2 V zwischen VDD und Sig misst, so würde beispielsweise gleichzeitig in ECU B (z. B. in der zweiten Energieversorgungseinheit 115) ein differenzieller Messwert zwischen GND und Sig in Höhe von (VDD-GND) - 2V gemessen werden können. Bei einer statischen 5 V-Versorgung (zwischen VDD und GND) würde in ECU B demnach 3 V gemessen werden. Sollte es zwischen beiden ECUs einen Masseversatz geben, so würde sich dieser zusätzlich in den Messsignalen widerspiegeln. Für eine präzise Ermittlung der physikalischen Größe sollte daher eine Möglichkeit vorgesehen sein, dass der Masseversatz im System gemessen werden kann.

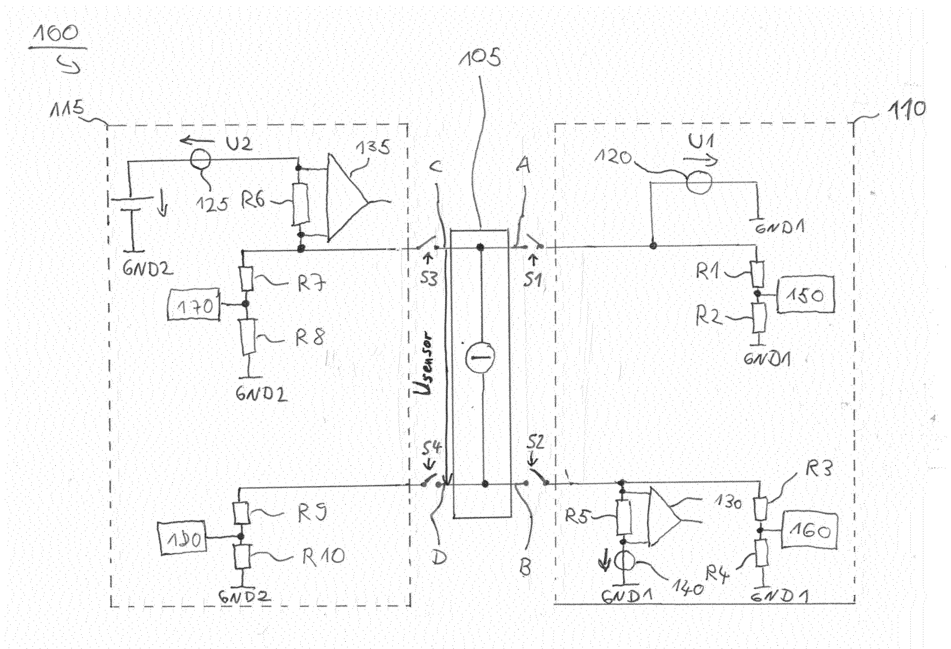

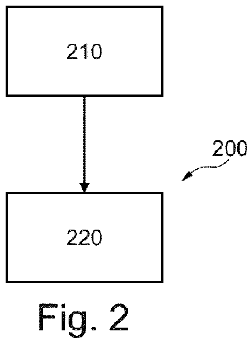

**Fig. 2** zeigt ein Ablaufdiagramm eines Ausführungsbeispiels des hier vorgestellten Ansatzes als Verfahren 200 zum Betreiben einer Variante eines hier beschriebenen Messsystems. Durch Ausführen des Verfahrens 200 zum Betreiben ist das Messsystem aus Fig. 1 oder ein ähnliches Messsystem vorteilhaft betreibbar. Das Verfahren 200 umfasst einen Schritt 210 des Versorgens des Messsensors mit elektrischer Energie aus der ersten und/oder zweiten Energieversorgungseinheit. Ferner umfasst das Verfahren 200 einen Schritt 220 des Ausgebens eines Messignals, welches den physikalischen Parameter repräsentiert, durch den Messsensor.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

### BEZUGSZEICHENLISTE

- 100: Messsystem
- 105: Messsensor
- 110: erste Energieversorgungseinheit
- 115: zweite Energieversorgungseinheit
- 120: erste Spannungsquelle
- 125: zweite Spannungsquelle
- 130: erste Verstärkungseinrichtung
- 135: zweite Verstärkungseinrichtung
- 140: zusätzliche Spannungsquelle
- 150: erste Steuereinrichtung
- 160: zweite Steuereinrichtung
- 170: dritte Steuereinrichtung
- 180: vierte Steuereinrichtung
- A: erster Anschluss
- B: zweiter Anschluss
- C: dritter Anschluss
- D: vierter Anschluss
- GND1: erstes Massepotenzial
- GND2: zweites Massepotenzial
- R1: erster Widerstand
- R2: zweiter Widerstand
- R3: dritter Widerstand
- R4: vierter Widerstand
- R5: fünfter Widerstand
- R6: sechster Widerstand
- R7: siebter Widerstand
- R8: achter Widerstand
- R9: neunter Widerstand
- R10: zehnter Widerstand
- S1: erster Schalter
- S2: zweiter Schalter
- S3: dritter Schalter
- S4: vierter Schalter
- U1: erste Spannung
- U2: zweite Spannung
- U_{Sensor}: Sensorspannung

- 200: Verfahren zum Betreiben eines Messsystems gemäß einer hier vorgestellten Variante
- 210: Schritt des Versorgens
- 220: Schritt des Ausgebens

## Patentansprüche

1. Messsystem (100) zur Erfassung eines physikalischen Parameters, wobei das Messsystem (100) die folgenden Merkmale aufweist:
- einen Messsensor (105) zur Erfassung des physikalischen Parameters, wobei der Messsensor (105) einen ersten Anschluss (A), einen zweiten Anschluss (B) und zumindest einen dritten Anschluss (C) aufweist;
- eine erste Energieversorgungseinheit (110) zur Ausgabe von elektrischer Energie an den Messsensor (105) über den ersten Anschluss (A) und den zweiten Anschluss (B), wobei die erste Energieversorgungseinheit (110) ausgebildet ist, um die elektrische Energie mit einer ersten Spannung (U1) in Bezug auf ein erstes Massepotenzial (GND1) an den Messsensor (105) auszugeben; und
- eine zweite Energieversorgungseinheit (115) zur Ausgabe von elektrischer Energie an den Messsensor (105) über den dritten Anschluss (C) und den zweiten Anschluss (B) oder einen vierten Anschluss (D), wobei die zweite Energieversorgungseinheit (115) ausgebildet ist, um die elektrische Energie mit einer zweiten Spannung (U2) in Bezug auf ein zweites Massepotenzial (GND2) an den Messsensor (105) auszugeben, insbesondere wobei das erste Massepotenzial (GND1) zumindest temporär von dem zweiten Massepotenzial (GND2) abweicht,
**dadurch gekennzeichnet, dass**
die erste Energieversorgungseinheit (110) eine zusätzliche Spannungsquelle (140) aufweist, wobei der zweite Anschluss (B) des Messsensors (105) über die zusätzliche Spannungsquelle (140) mit dem ersten Massepotenzial (GND1) elektrisch verbunden ist.

2. Messsystem (100) gemäß Anspruch 1, **dadurch gekennzeichnet, dass** die erste Energieversorgungseinheit (110) eine erste Spannungsquelle (120) für die erste Spannung (U1) und eine erste Steuereinrichtung (150) umfasst, wobei der erste Anschluss (A) des Messsensors (105) mit der ersten Spannungsquelle (120) und mit der ersten Steuereinrichtung (150) elektrisch verbunden ist, insbesondere wobei die erste Steuereinrichtung (150) über einen ersten Spannungsteiler (R1, R2) elektrisch mit dem ersten Anschluss (A) des Messsensors (105) und mit dem ersten Massepotenzial (GND1) verbunden ist.

3. Messsystem (100) gemäß einem der vorangegangenen Ansprüche, **dadurch gekennzeichnet, dass** die erste Energieversorgungseinheit (110) eine erste Verstärkungseinrichtung (130) und eine zweite Steuereinrichtung (160) umfasst, wobei der zweite Anschluss (B) des Messsensors (105) mit der ersten Verstärkungseinrichtung (130) und der zweiten Steuereinrichtung (160) elektrisch verbunden ist, insbesondere wobei die zweite Steuereinrichtung (160) über einen zweiten Spannungsteiler (R3, R4) elektrisch mit dem zweiten Anschluss (B) des Messsensors (105) und mit dem ersten Massepotenzial (GND1) verbunden ist.

4. Messsystem (100) gemäß einem der vorangegangenen Ansprüche, **dadurch gekennzeichnet, dass** die zweite Energieversorgungseinheit (115) eine zweite Spannungsquelle (125) für die zweite Spannung (U2), eine zweite Verstärkungseinrichtung (135) und eine dritte Steuereinrichtung (170) umfasst, wobei der dritte Anschluss (C) des Messsensors (105) mit der zweiten Spannungsquelle (125), mit der zweiten Verstärkungseinrichtung (135) und mit der dritten Steuereinrichtung (170) elektrisch verbunden ist, insbesondere wobei die dritte Steuereinrichtung (170) über einen dritten Spannungsteiler (R7, R8) elektrisch mit dem dritten Anschluss (C) des Messsensors (105) und mit dem zweiten Massepotenzial (GND2) verbunden ist.

5. Messsystem (100) gemäß einem der vorangegangenen Ansprüche, **dadurch gekennzeichnet, dass** die zweite Energieversorgungseinheit (115) eine vierte Steuereinrichtung (180) umfasst, wobei der zweite Anschluss (B) oder der vierte Anschluss (D) des Messsensors (105) mit der vierten Steuereinrichtung (180) elektrisch verbunden ist, insbesondere wobei die vierte Steuereinrichtung (180) über einen vierten Spannungsteiler (R9, R10) elektrisch mit dem zweiten Anschluss (B) oder dem vierten Anschluss (D) des Messsensors (105) und mit dem zweiten Massepotenzial (GND2) verbunden ist.

6. Messsystem (100) gemäß einem der vorangegangenen Ansprüche, **dadurch gekennzeichnet, dass** der Messsensor (105) als Drehzahlsensor ausgebildet ist, insbesondere um eine Drehzahl einer Komponente eines Fahrzeugs und/oder eines Rads eines Fahrzeugs zu erfassen.

7. Verfahren (200) zur Verwendung eines Messsystems (100) gemäß einem der vorangegangenen Ansprüche 1 bis 6, wobei das Verfahren (200) die folgenden Schritte umfasst:
- Versorgen (210) des Messsensors (105) mit elektrischer Energie aus der ersten und/oder zweiten Energieversorgungseinheit (110, 115); und
- Ausgeben (220) eines Messignals durch den Messsensor (105), wobei das Messignal den physikalischen Parameter repräsentiert.

8. Computerprogramm, umfassend Befehle, die bei der Ausführung des Programms durch einen Computer diesen veranlassen, das Verfahren (200) nach Anspruch 7 auszuführen.

9. Maschinenlesbares Speichermedium, auf dem das Computerprogramm nach Anspruch 8 gespeichert ist.

## Claims

1. Measuring system (100) for detecting a physical parameter, wherein the measuring system (100) has the following features:
- a measuring sensor (105) for detecting the physical parameter, wherein the measuring sensor (105) has a first terminal (A), a second terminal (B) and at least one third terminal (C);
- a first power supply unit (110) for outputting electrical energy to the measuring sensor (105) via the first terminal (A) and the second terminal (B), wherein the first power supply unit (110) is designed to output the electrical energy to the measuring sensor (105) with a first voltage (U1) with respect to a first ground potential (GND1); and
- a second power supply unit (115) for outputting electrical energy to the measuring sensor (105) via the third terminal (C) and the second terminal (B) or a fourth terminal (D), wherein the second power supply unit (115) is designed to output the electrical energy to the measuring sensor (105) with a second voltage (U2) with respect to a second ground potential (GND2), in particular wherein the first ground potential (GND1) differs at least temporarily from the second ground potential (GND2),
**characterized in that**
the first power supply unit (110) has an additional voltage source (140), wherein the second terminal (B) of the measuring sensor (105) is electrically connected via the additional voltage source (140) to the first ground potential (GND1).

2. Measuring system (100) according to claim 1, **characterized in that** the first power supply unit (110) includes a first voltage source (120) for the first voltage (U1) and a first control device (150), wherein the first terminal (A) of the measuring sensor (105) is electrically connected to the first voltage source (120) and to the first control device (150), in particular wherein the first control device (150) is electrically connected via a first voltage divider (R1, R2) to the first terminal (A) of the measuring sensor (105) and to the first ground potential (GND1).

3. Measuring system (100) according to any of the preceding claims, **characterized in that** the first power supply unit (110) comprises a first amplification device (130) and a second control device (160), wherein the second terminal (B) of the measuring sensor (105) is electrically connected to the first amplification device (130) and the second control device (160), in particular wherein the second control device (160) is electrically connected via a second voltage divider (R3, R4) to the second terminal (B) of the measuring sensor (105) and to the first ground potential (GND1).

4. Measuring system (100) according to any of the preceding claims, **characterized in that** the second power supply unit (115) comprises a second voltage source (125) for the second voltage (U2), a second amplification device (135) and a third control device (170), wherein the third terminal (C) of the measuring sensor (105) is electrically connected to the second voltage source (125), to the second amplification device (135) and to the third control device (170), in particular wherein the third control device (170) is electrically connected via a third voltage divider (R7, R8) to the third terminal (C) of the measuring sensor (105) and to the second ground potential (GND2).

5. Measuring system (100) according to any of the preceding claims, **characterized in that** the second power supply unit (115) comprises a fourth control device (180), wherein the second terminal (B) or the fourth terminal (D) of the measuring sensor (105) is electrically connected to the fourth control device (180), in particular wherein the fourth control device (180) is electrically connected via a fourth voltage divider (R9, R10) to the second terminal (B) or the fourth terminal (D) of the measuring sensor (105) and to the second ground potential (GND2).

6. Measuring system (100) according to any of the preceding claims, **characterized in that** the measuring sensor (105) is designed as a rotation rate sensor, in particular in order to detect a rotation speed of a component of a vehicle and/or of a wheel of a vehicle.

7. Method (200) for using a measuring system (100) according to any of the preceding claims 1 to 6, wherein the method (200) comprises the following steps:
- supplying (210) the measuring sensor (105) with electrical energy from the first and/or second power supply units (110, 115); and
- outputting (220) a measuring signal on the part of the measuring sensor (105), wherein the measuring signal represents the physical parameter.

8. Computer program, comprising commands which, when the programme is executed by a computer, cause the computer to execute the method (200) according to claim 7.

9. Machine-readable storage medium on which the computer program according to claim 8 is stored.

## Revendications

1. Système de mesure (100) pour détecter un paramètre physique, dans lequel le système de mesure (100) présente les caractéristiques suivantes :
- un capteur de mesure (105) pour détecter le paramètre physique, dans lequel le capteur de mesure (105) présente une première connexion (A), une deuxième connexion (B) et au moins une troisième connexion (C) ;
- une première unité d'alimentation en énergie (110) pour distribuer de l'énergie électrique au capteur de mesure (105) par le biais de la première connexion (A) et de la deuxième connexion (B), dans lequel la première unité d'alimentation en énergie (110) est conçue pour distribuer l'énergie électrique avec une première tension (U1) par rapport à un premier potentiel de terre (GND1) au capteur de mesure (105) ; et
- une deuxième unité d'alimentation en énergie (115) pour distribuer de l'énergie électrique au capteur de mesure (105) par le biais de la troisième connexion (C) et de la deuxième connexion (B) ou d'une quatrième connexion (D), dans lequel la deuxième unité d'alimentation en énergie (115) est conçue afin de distribuer l'énergie électrique avec une deuxième tension (U2) par rapport à un deuxième potentiel de terre (GND2) au capteur de mesure (105), en particulier dans lequel le premier potentiel de terre (GND1) s'écarte au moins temporairement du deuxième potentiel de terre (GND2),
**caractérisé en ce que**
la première unité d'alimentation en énergie (110) présente une source de tension supplémentaire (140), dans lequel la deuxième connexion (B) du capteur de mesure (105) est reliée électriquement au premier potentiel de terre (GND1) via la source de tension supplémentaire (140).

2. Système de mesure (100) selon la revendication 1, **caractérisé en ce que** la première unité d'alimentation en énergie (110) comprend une première source de tension (120) pour la première tension (U1) et un premier dispositif de commande (150), dans lequel la première connexion (A) du capteur de mesure (105) est reliée électriquement à la première source de tension (120) et au premier dispositif de commande (150), en particulier dans lequel le premier dispositif de commande (150) est relié électriquement via un premier diviseur de tension (R1, R2) à la première connexion (A) du capteur de mesure (105) et au premier potentiel de terre (GND1).

3. Système de mesure (100) selon l'une quelconque des revendications précédentes, **caractérisé en ce que** la première unité d'alimentation en énergie (110) comprend un premier dispositif d'amplification (130) et un deuxième dispositif de commande (160), dans lequel la deuxième connexion (B) du capteur de mesure (105) est reliée électriquement au premier dispositif d'amplification (130) et au deuxième dispositif de commande (160), en particulier dans lequel le deuxième dispositif de commande (160) est relié électriquement via un deuxième diviseur de tension (R3, R4) à la deuxième connexion (B) du capteur de mesure (105) et au premier potentiel de terre (GND1).

4. Système de mesure (100) selon l'une quelconque des revendications précédentes, **caractérisé en ce que** la deuxième unité d'alimentation en énergie (115) comprend une deuxième source de tension (125) pour la deuxième tension (U2), un deuxième dispositif d'amplification (135) et un troisième dispositif de commande (170), dans lequel la troisième connexion (C) du capteur de mesure (105) est reliée électriquement à la deuxième source de tension (125), au deuxième dispositif d'amplification (135) et au troisième dispositif de commande (170), en particulier dans lequel le troisième dispositif de commande (170) est relié électriquement, via un troisième diviseur de tension (R7, R8), à la troisième connexion (C) du capteur de mesure (105) et au deuxième potentiel de terre (GND2).

5. Système de mesure (100) selon l'une quelconque des revendications précédentes, **caractérisé en ce que** la deuxième unité d'alimentation en énergie (115) comprend un quatrième dispositif de commande (180), dans lequel la deuxième connexion (B) ou la quatrième connexion (D) du capteur de mesure (105) est reliée électriquement au quatrième dispositif de commande (180), en particulier dans lequel le quatrième dispositif de commande (180) est relié électriquement via un quatrième diviseur de tension (R9, R10) à la deuxième connexion (B) ou à la quatrième connexion (D) du capteur de mesure (105) et au deuxième potentiel de terre (GND2).

6. Système de mesure (100) selon l'une quelconque des revendications précédentes, **caractérisé en ce que** le capteur de mesure (105) est conçu comme capteur de vitesse de rotation, en particulier pour détecter une vitesse de rotation d'un composant d'un véhicule et/ou d'une roue d'un véhicule.

7. Procédé (200) d'utilisation d'un système de mesure (100) selon l'une quelconque des revendications précédentes 1 à 6, dans lequel le procédé (200) comprend les étapes suivantes :
- alimenter (210) le capteur de mesure (105) en énergie électrique à partir de la première et/ou deuxième unité d'alimentation en énergie (110, 115) ; et
- délivrer (220) un signal de mesure par le capteur de mesure (105), dans lequel le signal de mesure représente le paramètre physique.

8. Programme informatique, comprenant des instructions qui, lorsque le programme est exécuté par un ordinateur, amènent celui-ci à exécuter le procédé (200) selon la revendication 7.

9. Support de stockage lisible par machine, sur lequel le programme informatique selon la revendication 8 est stocké.
